# EUROPEAN PATENT APPLICATION

(11) **EP 1 793 494 A1**
(43) Date of publication of application: **06.06.2007**
(21) Application number: 06024142.9
(22) Date of filing: 21.11.2006
(51) Int. Cl.: H03H 7/48

(54) **Signal divider**

(30) Priority: 05.12.2005 JP 2005350508
(71) Applicant: Nippon Antena Kabushiki Kaisha, Tokyo 116-0011 (JP)
(72) Inventor: Shimizu, Hiroshi, c/o Nippon Antena K. K., Warabi-shi Saitama 335-0001 (JP); Itakura, Yasunori, c/o Nippon Antena K. K., Warabi-shi Saitama 335-0001 (JP)
(74) Representative: Grünecker, Kinkeldey, Stockmair & Schwanhäusser Anwaltssozietät

(57) **Abstract**

A signal divider 1 can be miniaturized in which divided signals do not interfere with each other and, at the same time, DC power does not creep into each other.

Since a signal dividing circuit 11 is a lumped constant circuit and each element can be made as a chip element, the signal divider 1 can be miniaturized. A division ratio of divided signal output from a first division output terminal OUT1 and a second division output terminal OUT2 can be set by a circuit A and a circuit B. Since a circuit C is connected in parallel with a series circuit composed of the circuit A and the circuit B to produce resonance at a usage frequency, a sufficient amount of isolation between the first division output terminal OUT1 and the second division output terminal OUT2 can be guaranteed. DC power supplied from the first division output terminal OUT1 and the second division output terminal OUT2 can be prevented from creeping out by the capacitors C2, C4.

## Description

### TECHNICAL FIELD

The present invention relates to a signal divider for dividing high frequency signals such as GPS signals.

### BACKGROUND ART

Nowadays, a car navigation system or an emergency contact request system using a global positioning system (GPS) as on-vehicle equipment may be mounted. Each of these two systems has a GPS antenna and a GPS signal has been supplied to each system through each GPS antenna. When two GPS systems are used with two GPS antennas mounted in a single vehicle, a mounting location is limited in a small area to receive the GPS signal satisfactorily; at the same time, a trunk cable up to each set becomes necessary, requiring complicated work for mounting and leading to higher costs. Moreover, a plurality of antennas mounted on a roof may cause disfigurement.

### DISCLOSURE OF THE INVENTION

### Problem that the invention is intended to solve

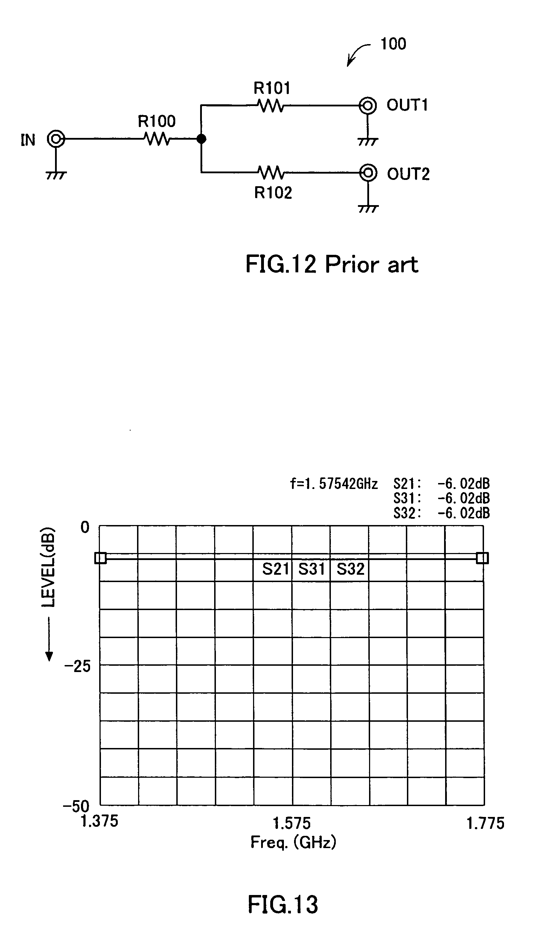

As a solution to the above problems, providing one signal divider that divides a GPS signal received by one GPS antenna to supply the GPS signal to each set can be considered. FIG. 12 illustrates a configuration of a prior signal divider used as such a signal divider. A dividing circuit 100 shown in FIG. 12 is assumed to be a Y-junction power dividing circuit, and one end of a first resistor R100 is connected to an input terminal IN and the other end of the first resistor R100 is connected to one end of a second resistor R101 and a third resistor R102. The other end of the second resistor R101 is connected to a first division output terminal OUT1 and the other end of the third resistor R102 is connected to a second division output terminal OUT2. In the dividing circuit 100, a signal input into the input terminal IN can be equally divided to the first division output terminal OUT1 and the second division output terminal OUT2. Since the dividing circuit 100 is configured of resistance elements only, pass losses and impedances of input/output terminals do not depend on frequencies and, at the same time, impedance between the input/output terminals can be easily adjusted.

FIG. 13 shows pass characteristics of the dividing circuit 100 when a resistance value of the first resistor R100 through third resistor R102 are set so that impedances of the input terminal IN, first division output terminal OUT1, and second division output terminal OUT2 of the dividing circuit 100 become 50 Ω. FIG. 13 shows the pass characteristics in the range of frequency of 1.375 GHz to 1.775 GHz; an attenuation of a transfer factor S21 from the input terminal IN to the first division output terminal OUT1 and that of a transfer factor S31 from the input terminal IN to the second division output terminal OUT2 are both about -6.02 dB over all range of frequencies. A transfer factor S32 from the first division output terminal OUT1 to the second division output terminal OUT2 shows isolation between both terminals and an attenuation thereof is also about -6.02 dB over all range of frequencies. Though frequency characteristics of impedance of each terminal of the dividing circuit 100 are not shown, the impedance of each terminal is 50 Ω, which is a design value, over all range of frequencies. Thus, impedance between each of terminals of the dividing circuit 100 can be easily adjusted, but the isolation between two output terminals is about -6 dB, which is an insufficient value and may lead to interference of divided signals with each other. Incidentally, the frequency of 1.57542 GHz is a frequency used for the GPS.

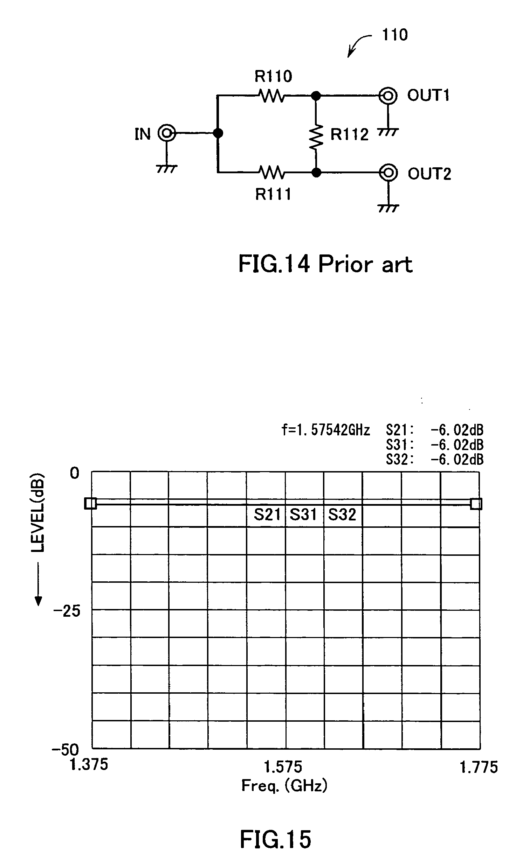

Next, FIG. 14 shows another example of the configuration of the prior signal divider. A dividing circuit 110 shown in FIG. 14 is assumed to be a delta-junction power dividing circuit; one end of a first resistor R110 and that of a second resistor R111 are connected to an input terminal IN, and the other end of the first resistor R110 is connected to one end of a third resistor R112 and a first division output terminal OUT1. Also, the other end of the second resistor R111 is connected to the other end of the third resistor R112 and a second division output terminal OUT2. In the dividing circuit 110, a signal input into the input terminal IN can be equally divided between the first division output terminal OUT1 and the second division output terminal OUT2. Since the dividing circuit 110 is configured of resistance elements only, pass losses and impedances of input/output do not depend on frequencies and, at the same time, impedance between the input/output can be easily adjusted.

FIG. 15 shows pass characteristics of the dividing circuit 110 when the resistance value of the first resistor R110 through third resistor R112 are set so that impedances of the input terminal IN, first division output terminal OUT1, and second division output terminal OUT2 of the dividing circuit 110 become 50 Ω. FIG. 15 shows the pass characteristics in the range of frequency of 1.375 GHz to 1.775 GHz; an attenuation of the transfer factor S21 from the input terminal IN to the first division output terminal OUT1 and that of the transfer factor S31 from the input terminal IN to the second division output terminal OUT2 are both about -6.02 dB over all range of frequencies. The transfer factor S32 from the first division output terminal OUT1 to the second division output terminal OUT2 shows isolation between both terminals and an attenuation thereof is also about -6.02 dB over all range of frequencies. Though frequency characteristics of impedance of each terminal of the dividing circuit 110 are not shown, the impedance of each terminal is 50 Ω, which is the design value, over all range of frequencies. Thus, impedance between each of terminals in the dividing circuit 110 can be easily adjusted, but the isolation between two output terminals is about -6 dB, which is an insufficient value and may lead to interference of divided signals with each other. Incidentally, the frequency of 1.57542 GHz is a frequency used for the GPS.

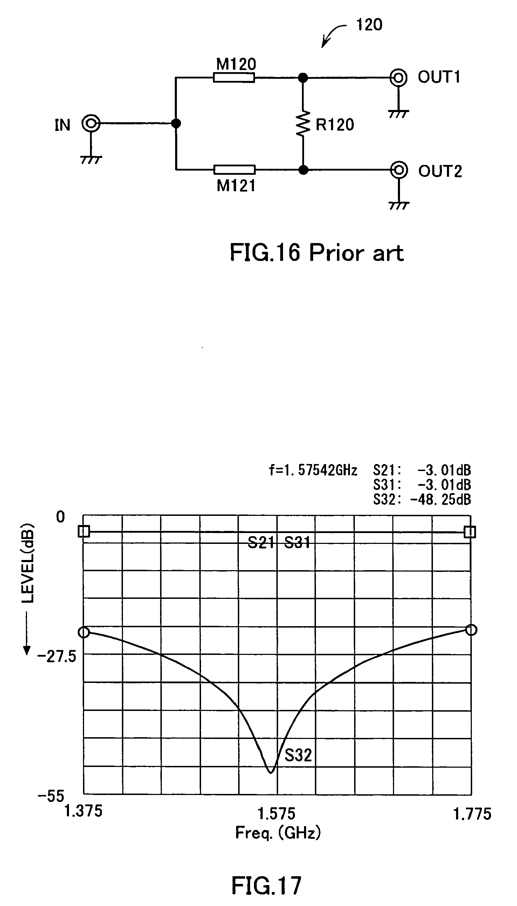

Next, FIG. 16 shows still another example of the configuration of the prior signal divider. A dividing circuit 120 shown in FIG. 16 is assumed to be a Wilkinson power dividing circuit, and one end of a first stripline M120 and that of a second stripline M121 are connected to an input terminal IN and the other end of the first stripline M120 is connected to one end of a resistor R120 and a first division output terminal OUT1. And, the other end of the second stripline M121 is connected to the other end of the resistor R120 and a second division output terminal OUT2. In the dividing circuit 120, a signal input into the input terminal IN is equally divided to the first division output terminal OUT1 and the second division output terminal OUT2.

FIG. 17 shows pass characteristics of the dividing circuit 120 when, in the dividing circuit 120, the first stripline M120 and second stripline M121 have a length equal to 1/4 wavelength of a usage frequency and, at the same time, the resistance value of the resistor R120 is set so that impedances of the input terminal IN, first division output terminal OUT1, and second division output terminal OUT2 become 50 Ω. FIG. 17 shows the pass characteristics in the range of frequency of 1.375 GHz to 1.775 GHz; an attenuation of the transfer factor S21 from the input terminal IN to the first division output terminal OUT1 and that of the transfer factor S31 from the input terminal IN to the second division output terminal OUT2 are both about -3.01 dB over all range of frequencies. The transfer factor S32 from the first division output terminal OUT1 to the second division output terminal OUT2 shows isolation between both terminals and an attenuation thereof is -48.25 dB at the usage frequency of 1.57542 GHz and about -22 dB or below over all range of frequencies. Though frequency characteristics of impedance of each terminal of the dividing circuit 110 are not shown, the impedance of each terminal is approximately 50 Ω, which is the design value, over all range of frequencies.

Isolation in the dividing circuit 120 increases because two striplines of the length of 1/4 wavelength are connected in series between the first division output terminal OUT1 and second division output terminal OUT2 to form a stripline of 1/2 wavelength, and thus a phase of the first division output terminal OUT1 and that of the second division output terminal OUT2 are opposite to cancel out each other. Thus, the dividing circuit 120 is excellent in isolation characteristics between two output terminals. On the other hand, since division ratio and impedance between each of terminals are adjusted by adjusting pattern lengths of the first stripline M120 and second stripline M121, a large area of the board of the dividing circuit 120 is needed. For example, the length of the first stripline M120 and that of the second stripline M121 having the length equal to 1/4 wavelength of the usage frequency are assumed to have the same length, and an example thereof is shown below:
Board material: Epoxy resin laminate; Thickness: 1.6 mm
   - Frequency: 500 MHz: Width: 1.6 mm; Length: 85.5 mm
   - Frequency: 1000 MHz: Width: 1.6 mm; Length: 42.7 mm
   - Frequency: 1.57542 GHz: Width: 1.6 mm; Length: 27.1 mm

As described above, there has been a problem that, if a GPS signal is divided by a prior signal divider, which is assumed to be a lumped constant circuit composed of resistance elements only, the signal divider can be miniaturized because chip elements are small, but insufficient isolation between output terminals may cause the signal divider to malfunction due to interference between divided GPS signals. Also, there has been a problem that, if a GPS signal is divided by a prior signal divider using striplines, isolation between output terminals becomes sufficient, but a large area of a board is needed for patterns of striplines and thus the signal divider cannot be miniaturized. Moreover, there has been a problem that, since two systems are configured in such a way that power is supplied to a GPS antenna by each system, power supplied to the GPS antenna in either of signal divider may creep into each other's system.

Therefore, an object of the present invention is to provide a signal divider that can be miniaturized in which divided signals do not interfere with each other and, at the same time, DC power does not creep into each other.

### Means for solving the problem

To achieve the above object, a signal divider according to the present invention includes lumped constant circuits and is characterized as the most main feature by having resonance produced in a usage band by parallel connection of a third circuit with a series circuit composed of a first circuit provided between an input terminal and a first division output terminal and a second circuit provided between the input terminal and a second division output terminal.

### Effect of the invention

Since, the signal divider according to the present invention includes lumped constant circuits and has resonance produced in a usage band by parallel connection of the third circuit with the series circuit composed of the first circuit provided between the input terminal and the first division output terminal and the second circuit provided between the input terminal and the second division output terminal, isolation between the first division output terminal and the second division output terminal is improved to prevent interference between divided signals. Also, since the signal divider according to the present invention includes lumped constant circuits and can be configured using small chip elements, the signal divider can be miniaturized. Furthermore, by using a circuit, through which DC power can pass, for the first circuit and using circuits, through which DC power cannot pass, for the second circuit and third circuit, DC power can be prevented from creeping out.

### BRIEF DESCRIPTION OF THE DRAWINGS

FIG. 1 is a block diagram showing a configuration a system example in which a signal divider according to an embodiment of the present invention is used.
FIG. 2 is a first circuit diagram of a dividing circuit in the signal divider according to the embodiment of the present invention.
FIG. 3 is a Smith chart showing frequency characteristics of impedance of the first dividing circuit in the signal divider according to the embodiment of the present invention.
FIG. 4 is a diagram showing frequency characteristics of pass loss of the first dividing circuit in the signal divider according to the embodiment of the present invention.
FIG. 5 is a second circuit diagram of the dividing circuit in the signal divider according to the embodiment of the present invention.
FIG. 6 is a Smith chart showing frequency characteristics of impedance of the second dividing circuit in the signal divider according to the embodiment of the present invention.
FIG. 7 is a diagram showing frequency characteristics of pass loss of the second dividing circuit in the signal divider according to the embodiment of the present invention.
FIG. 8 is a Smith chart showing frequency characteristics of impedance of the signal divider using the first dividing circuit according to the embodiment of the present invention.
FIG. 9 is a diagram showing frequency characteristics of pass loss of the signal divider using the first dividing circuit according to the embodiment of the present invention.
FIG. 10 is a Smith chart showing frequency characteristics of impedance of the signal divider using the second dividing circuit according to the embodiment of the present invention.
FIG. 11 is a diagram showing frequency characteristics of pass loss of the signal divider using the second dividing circuit according to the embodiment of the present invention.
FIG. 12 is a diagram showing a circuit configuration of a Y-junction power dividing circuit, which is a prior signal divider.
FIG. 13 is a diagram showing frequency characteristics of pass loss of the -junction power dividing circuit, which is a prior signal divider.
FIG. 14 is a diagram showing the circuit configuration of a delta-junction power dividing circuit, which is a prior signal divider.
FIG. 15 is a diagram showing frequency characteristics of pass loss of the delta-junction power dividing circuit, which is a prior signal divider.
FIG. 16 is a diagram showing the circuit configuration of a Wilkinson power dividing circuit, which is a prior signal divider.
FIG. 17 is a diagram showing frequency characteristics of pass loss of the Wilkinson power dividing circuit, which is a prior signal divider.

### BEST MODE FOR CARRYING OUT THE INVENTION

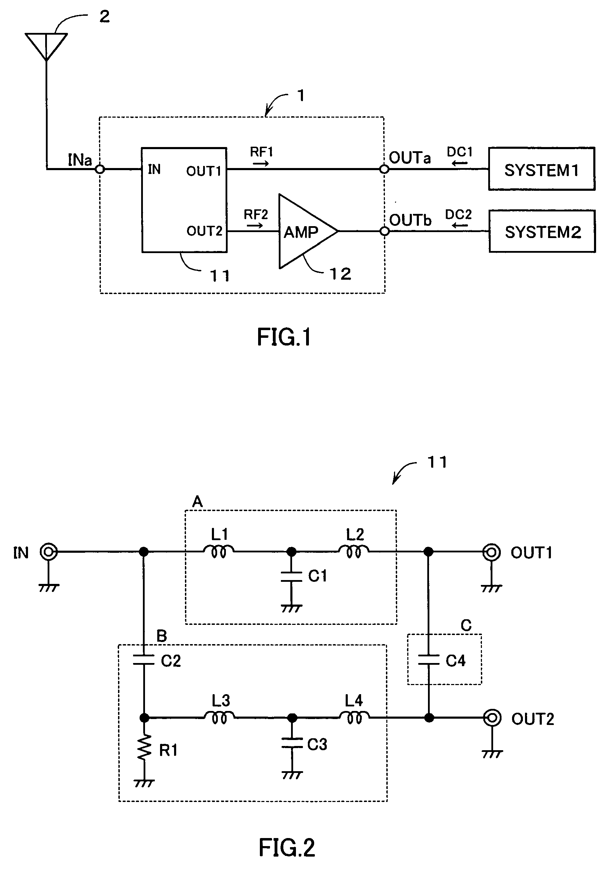

FIG. 1 shows a block diagram showing a configuration of a system example in which a signal divider according to an embodiment of the present invention is used.

The system shown in FIG. 1 includes, for example, a system 1 that is a car navigation system using the GPS and a system 2 that is an emergency contact request system using the GPS. The emergency contact request system is a system for providing a position obtained by using the GPS to a contact address in the occasion of an accident occurs or a sudden illness. An apparatus of the system 1 and that of the system 2 are mounted on a vehicle and an antenna 2 to be used in common is provided. A GPS signal received by the antenna 2, which a GPS antenna, is supplied to a signal divider 1 according to the present invention to be divided in two with a division ratio of 1:1 for supplying to the system 1 and system 2. The signal divider 1 includes an input terminal INa to which the antenna 2 is connected, and a first division output terminal OUTa and a second division output terminal OUTb for outputting signals divided in two are output.

The signal divider 1 includes a dividing circuit 11 for dividing a GPS signal by a predetermined division ratio and an amplification means (AMP) 12 for compensating for a division loss of a second division output (RF2) output from the dividing circuit 11. In this case, divided signals divided in two by the dividing circuit 11 are not at the rate of 1:1 and instead, a division loss of a first division output (RF1) output from the dividing circuit 11 is set to be small and that of the second division output (RF2) is set to be large. Thus, the AMP 12 is arranged to amplify only the second division output (RF2) to compensate for the division loss so that the division loss output from the first division output terminal OUTa and that output from the second division output terminal OUTb are approximately at the same level. Then, the divided signal from the first division output terminal OUTa is supplied to the system 1 and that from the second division output terminal OUTb is supplied to the system 2.

The system 1 and system 2 are capable of outputting DC power to be supplied to the GPS antenna from the input side. DC power (DC1) output from the input side of the system 1 is supplied to the first division output terminal OUTa of the signal divider 1, passes through the dividing circuit 11 included in the signal divider 1 and is supplied to the antenna 2 as operating power. DC power (DC2) output from the input side of the system 2 is supplied to the second division output terminal OUTb of the signal divider 1 to be supplied to the AMP 12 included in the signal divider 1, as operating power, but the DC power is prevented from passing through the dividing circuit 11. This prevents DC power supplied by the system 1 and system 2 from creeping out.

FIG. 2 shows a first circuit of the dividing circuit 11 in the signal divider 1 according to the embodiment of the present invention.

The first dividing circuit 11 shown in FIG. 2 includes lumped constant circuit and is comprised of a circuit A provided between the input terminal IN and the first division output terminal OUT1, a circuit B provided between the input terminal IN and the second division output terminal OUT2, and a circuit C provided between the first division output terminal OUT1 and second division output terminal OUT2. The circuit A is configured as a T-type low pass filter in which a first coil L1 and a second coil L2 are connected in series and a first capacitor C1 is connected between a connecting point of the first coil L1 and second coil L2 and a ground. By adjusting the pass loss between the input terminal IN and the first division output terminal OUT1 using the circuit A, the division ratio is set to be small, for example. The circuit A also has a function to adjust the impedance of input/output terminals of the dividing circuit 11. Incidentally, DC power supplied from the first division output terminal OUT1 is output from the input terminal IN via the circuit A to be supplied to the antenna 2 connected to the input terminal IN as operating power.

The circuit B has a second capacitor C2 connected in series and a first resistor R1 is connected between a back end of the second capacitor C2 and a ground. Between a connecting point of the second capacitor C2 and first resistor R1 and the second division output terminal OUT2, a T-type low pass filter in which a third coil L3 and a fourth coil L4 are connected in series and a third capacitor C3 is connected between a connecting point of the third coil L3 and fourth coil L4 and a ground. By adjusting the pass loss between the input terminal IN and the second division output terminal OUT2 using the circuit B, the division ratio is set to be large, for example. The circuit B also has a function to adjust the impedance of input/output terminals of the dividing circuit 11. Furthermore, DC power supplied from the second division output terminal OUT2 is prevented from being output from the input terminal IN by the second capacitor C2 and also prevented from creeping into the first division output terminal OUT1 by the circuit C. DC power supplied from the first division output terminal OUT1 is also prevented from creeping into the second division output terminal OUT2 similary.

The circuit C is comprised of a fourth capacitor C4 connected between the first division output terminal OUT1 and second division output terminal OUT2 and the fourth capacitor C4 is connected in parallel with a series circuit composed of the circuit A and the circuit B. The parallel circuit in which the fourth capacitor C4 is connected with the series circuit composed of the circuit A and circuit B is set so that parallel resonance is produced at the used frequency and therefore, isolation characteristics between the first division output terminal OUT1 and second division output terminal OUT2 can be made satisfactory.

Next, an example of values of each element for making impedances of the input terminal IN, the first division output terminal OUT1, and the second division output terminal OUT2 in the first dividing circuit 11 become 50 Ω when the usage frequency is set to 1.57542 GHz, which is used for a GPS system, in the first dividing circuit 11 shown in FIG. 2. Inductance of the first coil L1 and the second coil L2 are about 7.5 nH, that of the third coil L3 and the fourth coil L4 are about 2 nH, capacitance of the first capacitor C1 to about 2 pF, that of the second capacitor C2 and the fourth capacitor C4 are about 0.5 pF, and that of the third capacitor C3 is about 1 pF. Since each element can be made as a chip element, the first dividing circuit 11 can be integrated on a small-sized board.

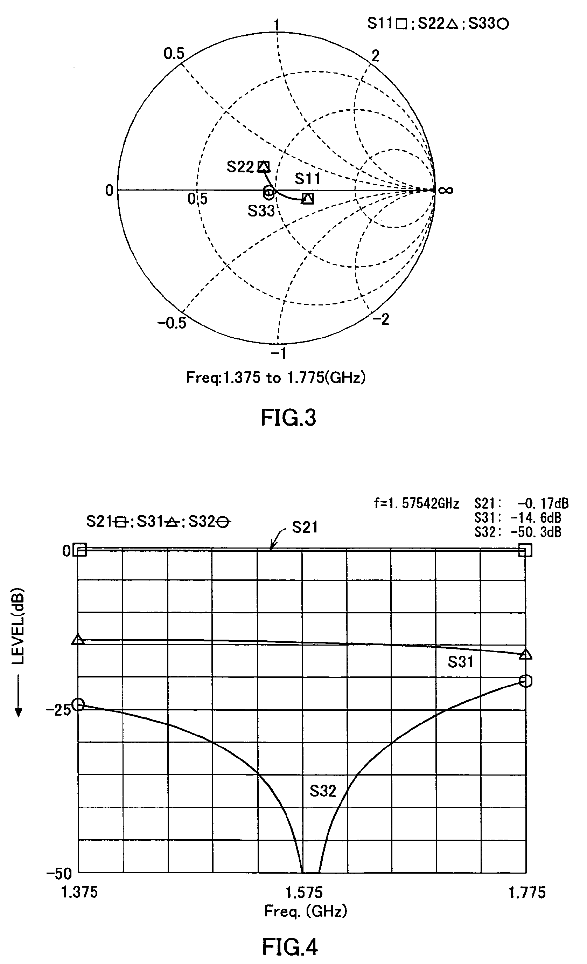

FIG. 3 shows a Smith chart showing frequency characteristics of impedance when each element in the first dividing circuit 11 shown in FIG. 2 has the values mentioned above. In FIG. 3, S 11 is a reflection coefficient at the input terminal IN, S22 is a reflection coefficient at the first division output terminal OUT1, and S33 is a reflection coefficient at the second division output terminal OUT2. FIG. 3 shows reflection characteristics between terminals in the range of frequencies 1.375 GHz to 1.775 GHz, which includes the usage frequency. The reflection coefficients S11, S22, and S33 are close to "1" on an axis showing normalized values of resistance indicated by 0 to ∞ over all range of frequencies. From the figure, it can be seen that resistances are well matched with rare reflection in each terminal at the usage frequency. Thus, in the first dividing circuit 11, each input/output terminal is made to show an impedance of about 50 Ω, which is a set value, in the range of frequencies including the usage frequency.

FIG. 4 shows frequency characteristics of pass loss when each element in the first dividing circuit 11 has the values mentioned above. In FIG. 4, S21 is a transfer factor from the input terminal IN to the first division output terminal OUT1, S31 is a transfer factor from the input terminal IN to the second division output terminal OUT2, and S32 is a transfer factor from the first division output terminal OUT1 to the second division output terminal OUT2. FIG. 4 shows pass loss characteristics of between terminals in the range of frequencies 1.375 GHz to 1.775 GHz including the usage frequency. Referring to FIG. 4, it can be seen that there is almost no pass loss indicated by the transfer factor S21 over all range of frequencies with a small amount of attenuation of about -0.17 dB at the usage frequency of 1.57542 GHz. Thus, the divided signal is transferred from the input terminal IN to the first division output terminal OUT1 with almost no attenuation over all range of frequencies. Also, the pass loss indicated by the transfer factor S31 is an attenuation of about -15 dB over all range of frequencies and an attenuation of about -14.6 dB at the usage frequency of 1.57542 GHz. Thus, the divided signal is transferred from the input terminal IN to the second division output terminal OUT2 with an attenuation of about -15 dB over all range of frequencies. Incidentally, the pass loss of about -15 dB at the second division output terminal OUT2 is a pass loss according to a set division ratio and the pass loss is compensated for by the AMP 12 connected to the second division output terminal OUT2. Further, the pass loss indicated by the transfer factor S32 is an attenuation of about -20 dB or more over all range of frequencies with an attenuation of about -50.3 dB at the usage frequency of 1.57542 GHz showing an excellent isolation value. Thus, the isolation of the first division output terminal OUT1 and the second division output terminal OUT2 is of an attenuation of -50 dB or more at the usage frequency showing that divided signals will not interfere with each other.

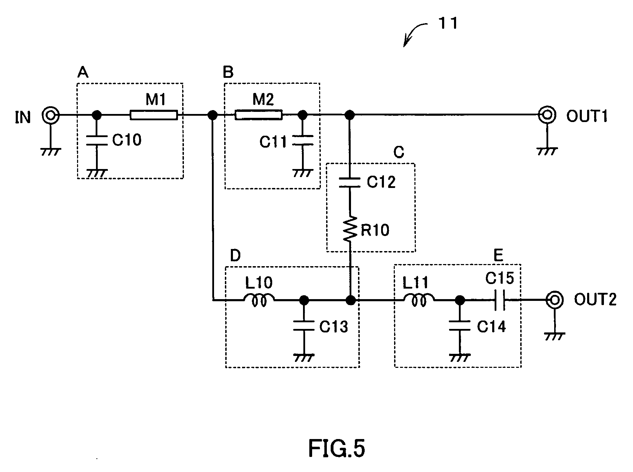

Next, FIG. 5 shows a second circuit of the dividing circuit 11 in the signal divider 1 according to an embodiment of the present invention.

The second dividing circuit 11 shown in FIG. 5 includes lumped constant circuit and is comprised of a circuit in which a circuit A and a circuit B are connected in series and which is provided between the input terminal IN and first division output terminal OUT1, a circuit in which a circuit D and a circuit E are connected in series and which is provided between a connecting point of the circuit A and circuit B and the second division output terminal OUT2, and a circuit C provided between the first division output terminal OUT1 and a connecting point of the circuit D and circuit E. The circuit A includes a first capacitor C 10 connected between the input terminal IN and a ground and a first stripline M1 whose one end is connected to the input terminal. The circuit Ais configured as a low pass filter and has a function to adjust the impedance of input/output terminals of the dividing circuit 11.

The circuit B includes a second stripline M2 whose one end is connected in series to the other end of the first stripline M1 in the circuit A and a second capacitor C11 connected between the other end of the second stripline M2 and a ground. The pass loss between the input terminal IN and first division output terminal OUT1 can be adjusted using the circuit B. The circuit B is also configured as a low pass filter and has a function to adjust the impedance of input/output terminals of the dividing circuit 11. Incidentally, DC power supplied from the first division output terminal OUT1 is output from the input terminal IN via the circuit B and circuit A to be supplied to the antenna 2 connected to the input terminal IN as operating power.

The circuit D includes a first coil L10 whose one end is connected to a connecting point of the circuit A and circuit B and a fourth capacitor C 13 connected between the other end of the first coil L10 and a ground. The circuit E includes a second coil L11 whose one end is connected in series to the circuit D, a sixth capacitor C 15 connected in series to the other end of the second coil L11, and a fifth capacitor C14 connected between a connecting point of the second coil L11 and sixth capacitor C15 and a ground. The division ratio between the first division output terminal OUT1 and second division output terminal OUT2 in the dividing circuit 11 is set by the circuit B and a series circuit composed of the circuit D and circuit E. For example, the division ratio is set so that division output of the first division output terminal OUT1 is large and division output of the second division output terminal OUT2 is small. Incidentally, the sixth capacitor C 15 is assumed to be a capacitor for DC cutoff. The circuit D and circuit E constitute a low pass filter and have a function to adjust the impedance of input/output terminals of the dividing circuit 11. Moreover, DC power supplied from the second division output terminal OUT2 is prevented by the sixth capacitor C15 from being output from the input terminal IN and the first division output terminal OUT1.

The circuit C includes a third capacitor C12 whose one end is connected to the first division output terminal OUT1 and a resistor R10 whose one end is connected in series to the other end of the third capacitor C12, and the other end of the resistor R10 is connected to a connecting point of the circuit D and circuit E. The circuit C is connected in parallel with a series circuit composed of the circuit B and circuit D. The circuit E is connected in series to the parallel circuit. The circuits connected between the first division output terminal OUT1 and second division output terminal OUT2 are made to resonate at the usage frequency and thus, isolation characteristics between the first division output terminal OUT1 and second division output terminal OUT2 can be made satisfactory. The third capacitor C12 is assumed to be a capacitor for DC cutoff. Moreover, DC power supplied from the first division output terminal OUT1 is output from the input terminal IN via the circuit B and circuit A to be supplied to the antenna 2 connected to the input terminal IN as operating power. However, DC power is prevented by the third capacitor C12 in the circuit C from creeping into the second division output terminal OUT2.

Next, an example of values of each element for making impedances of the input terminal IN, the first division output terminal OUT1, and the second division output terminal OUT2 in the first dividing circuit 11 become 50 Ω when the usage frequency is set to 1.57542 GHz, which is used for a GPS system, in the second dividing circuit 11 shown in FIG 5. When the board material is an epoxy resin laminate and the thickness thereof is 1.6 mm, the first stripline M1 is a pattern of about 1 mm in width and about 4 mm in length, and the second stripline M2 is a pattern of about 1 mm in width and about 11 mm in length. Inductance of the first coil L10 is about 33 nH and that of the second coil L11 is about 15 nH. Capacitance of the first capacitor C10 is about 1.5 pF, that of the second capacitor C11, fourth capacitor C13, and fifth capacitor C15 are about 1 pF. Capacitance of the third capacitor C12 and the sixth capacitor C15, which are for DC cutoff, is about 10000 pF, and resistance of the resistor R1 is about 390 Ω. Since a stripline can be formed as a pattern of about 11 mm at the longest and each of other elements can be made as a chip element, the second dividing circuit 11 can be integrated on a small-sized board. Incidentally, an inductor is obtained from the first stripline M1 and second stripline M2 in the second dividing circuit 11, but instead a coil of a lumped constant may also be used. Using a coil of a lumped constant can make the second dividing circuit 11 still smaller.

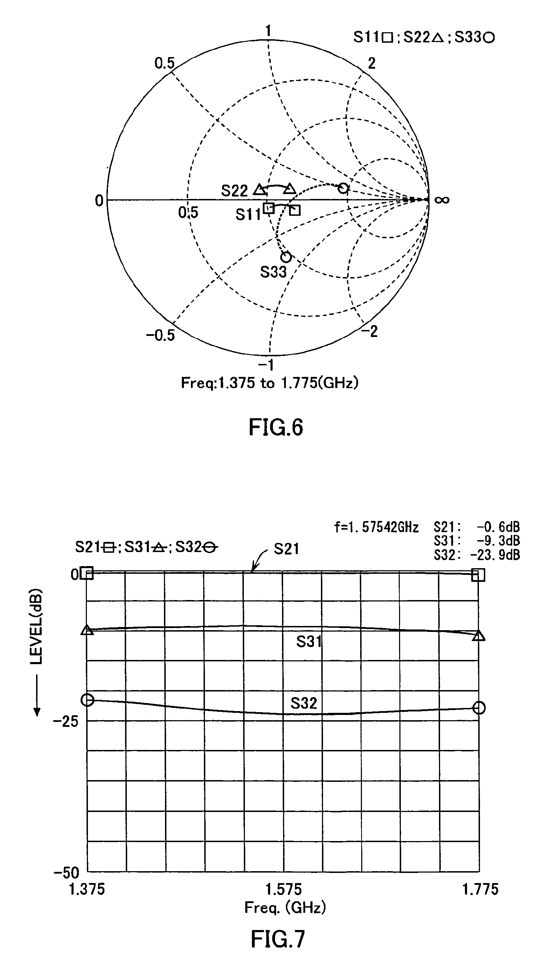

FIG. 6 shows a Smith chart showing frequency characteristics of impedance when each element in the second dividing circuit 11 shown in FIG. 5 has the values mentioned above. FIG. 6 shows reflection characteristics of each terminal in the range of frequencies 1.375 GHz to 1.775 GHz including the usage frequency; reflection coefficients S11 and S22 are close to "1" on the axis showing normalized values of resistance indicated by 0 to ∞ over all range of frequencies and a reflection coefficient S33 is close to "1" near the frequencies of 1.575 GHz. From the figure, it can be seen that the resistances are well matched with rare reflection in each terminal at the usage frequency. Thus, in the second dividing circuit 11, each input/output terminal is made to show an impedance of about 50 Ω, which is a set value, in the range of frequencies near the usage frequency.

FIG. 7 shows frequency characteristics of pass loss when each element in the second dividing circuit 11 has the values mentioned above. FIG. 7 shows pass loss characteristics of between terminals in the range of frequencies 1.375 GHz to 1.775 GHz including the usage frequency. Referring to FIG. 7, it can be seen that there is almost no pass loss indicated by the transfer factor S21 over all range of frequencies with a small amount of attenuation of about -0.6 dB at the usage frequency of 1.57542 GHz. Thus, the divided signal is transferred from the input terminal IN to the first division output terminal OUT1 with almost no attenuation over all range of frequencies. Also, the pass loss indicated by the transfer factor S31 is an attenuation of about -10 dB over all range of frequencies and an attenuation of about -9.3 dB at the usage frequency of 1.57542 GHz. Thus, the divided signal is transferred from the input terminal IN to the second division output terminal OUT2 with an attenuation of about -10 dB over all range of frequencies. Incidentally, the pass loss of about -10 dB at the second division output terminal OUT2 is a pass loss according to a set division ratio and the pass loss is compensated for by the AMP 12 connected to the second division output terminal OUT2. Further, the pass loss indicated by the transfer factor S32 is an attenuation of about -20 dB or more over all range of frequencies showing isolation of about -23.9 dB at the usage frequency of 1.57542 GHz. Thus, the isolation of the first division output terminal OUT1 and the second division output terminal OUT2 is of an attenuation of about -24 dB at the usage frequency showing that divided signals will not interfere with each other.

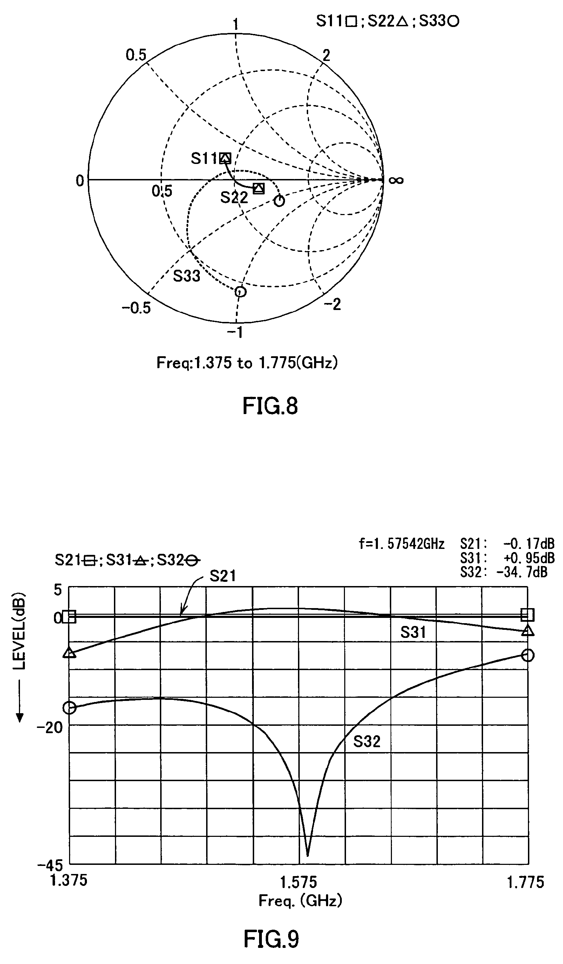

Next, FIG. 8 shows a Smith chart showing frequency characteristics of impedance of the signal divider 1 shown in FIG. 1 when the first dividing circuit 11 shown in FIG. 2 is used. In FIG. 8, S11 is a reflection coefficient at the input terminal INa, S22 is a reflection coefficient at the first division output terminal OUTa, and S33 is a reflection coefficient at the second division output terminal OUTb. FIG. 8 shows reflection characteristics of each terminal in the signal divider 1 in the range of frequencies 1.375 GHz to 1.775 GHz including the usage frequency; reflection coefficients S11 and S22 are close to "1" on the axis showing normalized values of resistance indicated by 0 to ∞ over all range of frequencies and a reflection coefficient S33 is close to "1" near the frequency of 1.575 GHz. From the figure, it can be seen that the resistances are well matched with rare reflection in each terminal at the usage frequency. Thus, in the signal divider 1, each terminal is made to show impedance set for the terminal in the range of frequencies near the usage frequency.

FIG. 9 shows frequency characteristics of pass loss of the signal divider 1 shown in FIG. 1 when the first dividing circuit 11 is used. FIG. 9 shows pass loss characteristics of between each terminal in the range of frequencies 1.375 GHz to 1.775 GHz including the usage frequency. Referring to FIG. 9, it can be seen that there is almost no pass loss from the input terminal INa to the first division output terminal OUTa indicated by the transfer factor S21 over all range of frequencies with a small amount of attenuation of about -0.17 dB at the usage frequency of 1.57542 GHz. Thus, the divided signal output from the first division output terminal OUTa will be output with almost no attenuation over all range of frequencies. Also, the pass loss from the input terminal INa to the second division output terminal OUTb indicated by the transfer factor S31 is an attenuation of about -7.5 dB or less over all range of frequencies with an attenuation of about +0.95 dB at the usage frequency of 1.57542 GHz. Thus, approximately the same level of divided signal will be obtained from the second division output terminal OUTb as that from the first division output terminal OUTa with compensation of pass loss in the dividing circuit 11 by the AMP 12. Further, the pass loss from the first division output terminal OUTa to the second division output terminal OUTb indicated by the transfer factor S32 is an attenuation of only about -7.5 dB or more over all range of frequencies, but isolation of an attenuation of about -34.7 dB is obtained at the usage frequency of 1.57542 GHz. Thus, the isolation of the first division output terminal OUTa and the second division output terminal OUTb is of sufficient attenuation at the usage frequency, showing that divided signals will not interfere with each other.

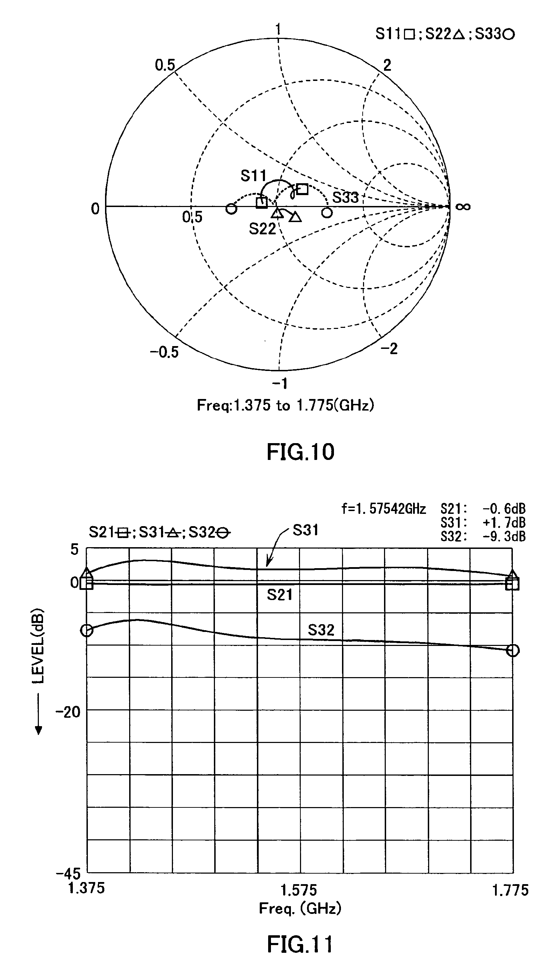

Next, FIG. 10 shows a Smith chart showing frequency characteristics of impedance of the signal divider 1 shown in FIG. 1 when the second dividing circuit 11 shown in FIG. 5 is used. FIG. 10 shows reflection characteristics of each terminal in the signal divider 1 in the range of frequencies 1.375 GHz to 1.775 GHz including the usage frequency; a reflection coefficient S11 at the input terminal INa is close to "1" on the axis showing normalized values of resistance indicated by 0 to ∞ at the usage frequency of 1.57542 GHz and a reflection coefficient S22 at the first division output terminal OUTa is close to "1" over all range of frequencies. Also, the reflection coefficient S33 in the second division output terminal OUTb is close to "1" at the usage frequency of 1.575 GHz. From the figure, it can be seen that resistances are well matched with rare reflection in each terminal at the usage frequency. Thus, in the signal divider 1, each terminal is made to show impedance set for the terminal in the range of frequencies near the usage frequency.

FIG. 11 shows frequency characteristics of pass loss of the signal divider 1 shown in FIG. 1 when the second dividing circuit 11 is used. FIG. 11 shows pass loss characteristics of between each terminal in the range of frequencies 1.375 GHz to 1.775 GHz including the usage frequency. Referring to FIG. 11, it can be seen that there is almost no pass loss from the input terminal INa to the first division output terminal OUTa indicated by the transfer factor S21 over all range of frequencies with a small amount of attenuation of about -0.6 dB at the usage frequency of 1.57542 GHz. Thus, the divided signal output from the first division output terminal OUT1 will be output with almost no attenuation over all range of frequencies. Also, the pass loss from the input terminal INa to the second division output terminal OUTb indicated by the transfer factor S31 shows no attenuation over all range of frequencies with about +1.7 dB identified at the usage frequency of 1.57542 GHz. Thus, approximately the same level of divided signal will be obtained from the second division output terminal OUTb as that from the first division output terminal OUTa with compensation of pass loss in the dividing circuit 11 by the AMP 12. Further, the pass loss from the first division output terminal OUTa to the second division output terminal OUTb indicated by the transfer factor S32 is an attenuation of only about -6 dB or more over all range of frequencies, but isolation of an attenuation of about -9.3 dB is obtained at the usage frequency of 1.57542 GHz. Thus, the isolation of the first division output terminal OUTa and the second division output terminal OUTb is of moderate attenuation at the usage frequency, showing that divided signals will not interfere with each other.

As has been described, the first dividing circuit 11 and the second dividing circuit 11 in the signal divider 1 according to the present invention obtain sufficient isolation by configuring a resonance circuit between the first division output terminal OUT1 and second division output terminal OUT2. Since the resonance circuit can have resonance produced at a predetermined frequency by freely combining coils and capacitors, excellent isolation can be obtainable not only at the frequency used for the GPS, but also at any usage frequency.

In the first dividing circuit 11, the parallel circuit, in which the fourth capacitor C4 is connected in parallel with the series circuit composed of the circuit A and circuit B, is made to parallel-resonate at the usage frequency, but the resonance is produced in a predetermined range of usage band including the usage frequency, not at a point of the usage frequency. Similarly, in the second dividing circuit 11, the circuit, in which the circuit C is connected in parallel with the series circuit composed on the circuit B and circuit D and the circuit E is connected in series with the parallel circuit, is made to resonate at the usage frequency, but the resonance is produced in a predetermined range of usage band including the usage frequency, not at a point of the usage frequency.

### INDUSTRIAL APPLICABILITY

A signal divider that divides a GPS signal has been described thus far, but the present invention is not limited to this and can be applied to any signal divider that divides a high frequency signal in two so that both divided signals are at the same output level.

## Claims

1. A signal divider that divides a signal input from an input terminal in two to output to a first division output terminal and a second division output terminal, comprising:
a first circuit provided between the input terminal and the first division output terminal to set a division ratio by adjusting a pass loss in a usage band;
a second circuit provided between the input terminal and the second division output terminal to set the division ratio by adjusting the pass loss in the usage band; and
a third circuit provided between the first division output terminal and the second division output terminal that is made to resonate in the usage band by parallel connection with a series circuit composed of the first circuit and second circuit, wherein
the first circuit through the third circuit are lumped constant circuits.

2. The signal divider according to claim 1, wherein the pass loss of the second circuit is set to be larger than that of the first circuit and an amplification means is provided for compensating for the pass loss of the second circuit.

3. The signal divider according to claim 1, wherein the first circuit is a circuit, through which DC power can pass, and DC power supplied by the first division output terminal is supplied to a signal output means connected to the input terminal, and the second circuit and the third circuit are circuits, through which DC power cannot pass, and DC power supplied by the second division output terminal is supplied only to the amplification means.

4. The signal divider according to claim 1, wherein the first circuit adjusts impedance between the input terminal and the first division output terminal and the second circuit adjusts impedance between the input terminal and the second division output terminal.

5. A signal divider that divides a signal input from an input terminal in two to output to a first division output terminal and a second division output terminal, comprising:
a first circuit and a second circuit provided in series between the input terminal and first division output terminal, wherein the first circuit is for adjusting impedance and the second circuit is for setting a division ratio by adjusting a pass loss in a usage band;
a third circuit and a fourth circuit for setting the division ratio by adjusting the pass loss in the usage band, the third circuit and the fourth circuit are provided in series between a connecting point of the first circuit and second circuit and the second division output terminal; and
a fifth circuit connected in parallel with a series circuit composed of the second circuit and third circuit, the fifth circuit is provided between the first division output terminal and a connecting point of the third circuit and fourth circuit, wherein
the fifth circuit is parallel-connected with the series circuit composed of the second circuit and third circuit, further the fourth circuit is connected in series to make the circuits to resonate in a usage band, and at least the third circuit through the fifth circuit are lumped constant circuits.

6. The signal divider according to claim 5, wherein the pass loss of the third circuit and the fourth circuit connected in series is set to be larger than that of the second circuit and an amplification means is provided for compensating for the pass loss of the third circuit and the fourth circuit.

7. The signal divider according to claim 5, wherein the first circuit and the second circuit are circuits, through which DC power can pass, and DC power supplied by the first division output terminal is supplied to a signal output means connected to the input terminal, and the fourth circuit and the fifth circuit are circuits, through which DC power cannot pass, and DC power supplied by the second division output terminal is supplied only to the amplification means.
